Europäisches Patentamt

European Patent Office

Office européen des brevets

(11) Numéro de publication: **0 481 416 A1**

# (12) DEMANDE DE BREVET EUROPEEN

(21) Numéro de dépôt: 91117513.1

(22) Date de dépôt: 14.10.91

(51) Int. Cl.5: **H01J 37/32**, H01J 37/34, H05H 1/46

(30) Priorité: **18.10.90 FR 9012897**

(43) Date de publication de la demande:
**22.04.92 Bulletin 92/17**

(84) Etats contractants désignés:
**AT BE CH DE DK ES FR GB GR IT LI LU NL SE**

(71) Demandeur: **ALCATEL CIT**
**12 Rue de la Baume**
**F-75008 Paris(FR)**

(72) Inventeur: **Ravel, Guillaume**
**63, chemin du Périmètre**
**F-74000 Annecy(FR)**

(74) Mandataire: **Weinmiller, Jürgen et al**
**Lennéstrasse 9 Postfach 24**
**W-8133 Feldafing(DE)**

(54) **Machine de dépôt par pulvérisation cathodique.**

(57) L'invention concerne une machine de dépôt par pulvérisation cathodique comprenant une enceinte de dépôt, un plasma pouvant être créé dans l'enceinte par un mécanisme de résonance cyclotronique électronique induit par des ensembles situés de part et d'autre de la cathode (14), chaque ensemble comprenant un applicateur filaire (11) et un barreau magnétique (12), un barreau magnétique central (15) étant disposé entre les deux ensembles. Des barreaux magnétiques de bouclage (16) assurent, avec les barreaux magnétiques (12) desdits ensembles, l'encadrement de la cathode, ces barreaux magnétiques d'encadrement présentant une polarité inverse de celle du barreau magnétique central.

FIG.2

EP 0 481 416 A1

Rank Xerox (UK) Business Services

La présente invention concerne une machine de dépôt par pulvérisation cathodique dans laquelle le plasma luminescent est créé par un mécanisme de résonance cyclotronique électronique.

Les plasmas luminescents sont aussi bien utilisés dans les machines de gravure que dans les machines de dépôt. Pour créer un milieu plasma pour le traitement sous vide, on utilise couramment le mécanisme de résonance cyclotronique électronique (RCE). On peut ainsi créer un plasma de haute densité ($10^{11}$ électrons par $cm^3$) à partir d'un gaz à basse pression (de l'ordre de 0,1 Pa).

Les méthodes classiques utilisées pour créer un milieu plasma présentent des inconvénients majeurs qui proviennent de :
- l'utilisation d'une source hyperfréquence quasi ponctuelle (limitée à la taille du guide d'onde véhiculant l'onde électromagnétique à 2,45 GHz),
- l'isolement électrique et l'étanchéité vis-à-vis du vide régnant dans l'enceinte de traitement,
- la géométrie du champ magnétique requis pour la résonance qui favorise le mouvement d'électrons rapides de la zone de résonance jusqu'au substrat à traiter provoquant un bombardement énergétique préjudiciable au substrat,
- la difficulté d'obtenir un plasma dense et homogène sur des substrats de grande surface.

Pour pallier la plupart de ces inconvénients, le document FR 2 583 250 divulgue l'association des aimants de confinement, classiquement utilisés en technologie RCE pour créer le champ de 875 gauss requis pour la résonance à 2,45 GHz, à des applicateurs filaires qui sont des antennes situées face aux aimants. Cette association constitue ce que l'on appelle la technologie de résonance cyclotronique électronique répartie. La technologie RCE répartie a été mise en oeuvre pour concevoir un réacteur de gravure en plasma à basse pression et haute densité. La mise en oeuvre de cette technologie a cependant fait apparaître d'autres difficultés qui sont les suivantes :
- la faculté d'accroître le diamètre de la chambre du réacteur en augmentant le nombre de sources (c'est-à-dire les ensembles applicateur filaire-aimant) tout en respectant le nombre de pôles conduit à devoir maîtriser la répartition égale de l'onde électromagnétique sur chacune des sources normalement en grand nombre (plus de dix);
- la géométrie du champ magnétique créé par les barreaux magnétiques (servant d'aimants) utilisés face aux applicateurs filaires fait apparaître, à cause de la polarité des aimants et à cause du gradient de champ existant perpendiculairement aux applicateurs (sur les rayons dans le cas d'une enceinte cylindrique), une dérive des électrons en sens inverse sur chaque lobe de lignes de champ.

Ces deux phénomènes sont également présents dans le cas d'une enceinte parallélépipéde où l'on procède avec un plan d'aimants et d'applicateurs filaires.

Dans le domaine particulier du dépôt physique sous vide, il a été proposé (voir l'article :"An électron cyclotron résonance plasma déposition technique employing magnetron mode sputtering" par C.TAKAHASHI, M. KIUCHI, T.ONO et S. MATSUO paru dans J. Vac. Sci. Technol. A 6(4), Jul/Aug 1988) de disposer au voisinage de la zone de résonance, dans le cas d'un dispositif utilisant le mécanisme RCE, une électrode comportant un matériau à pulvériser. Cette électrode, polarisable en continu ou en alternatif, est classiquement portée à un potentiel négatif par rapport au milieu plasma . Le phénomène de pulvérisation de la surface de l'électrode se produit à un haut rendement puisqu'il est assisté par le plasma de haute densité de la source RCE. Néanmoins, la limitation géométrique inhérente au principe de la source RCE quasi ponctuelle existe toujours, de même que les autres inconvénients cités plus haut.

Le but de la présente invention est la réalisation d'une machine de dépôt par pulvérisation cathodique qui ne présente pas ces inconvénients. Ce résultat a été atteint par un arrangement particulier d'aimants ou de barreaux magnétiques autour de la cathode de pulvérisation.

L'invention a donc pour objet une machine de dépôt par pulvérisation cathodique comprenant une enceinte de dépôt contenant un gaz maintenu à pression réduite et destiné à constituer un plasma par un mécanisme de résonance cyclotronique électronique, l'enceinte renfermant une cathode comportant le matériau à pulvériser et placée au voisinage de la zone de résonance, caractérisée en ce que :
- le mécanisme de résonance cyclotronique électronique est créé par des ensembles situés de part et d'autre de la cathode, chaque ensemble comprenant un applicateur filaire et un barreau magnétique,
- un barreau magnétique, dit barreau magnétique central est également disposé entre les deux ensembles et parallèlement à ceux-ci,
- des barreaux magnétiques de bouclage sont disposés à proximité de la cathode de manière à réaliser, avec les barreaux magnétiques desdits ensembles, l'encadrement de la cathode et du barreau magnétique central,
- les barreaux magnétiques d'encadrement présentent tous une même polarité alors que le barreau magnétique central présente une polarité inverse.

L'invention sera mieux comprise et d'autres avantages apparaîtront à la lecture de la description qui va suivre, donnée à titre non limitatif, accompagnée par les dessins annexés parmi lesquels :

- la figure 1 représente un arrangement de sources de résonance cyclotronique électronique selon l'art connu,
- la figure 2 représente, de façon schématique, la configuration interne de l'enceinte d'une machine de dépôt selon l'invention.

La résonance cyclotronique électronique (RCE) résulte de la combinaison d'un champ électromagnétique hyperfréquence et d'un champ magnétique statique qui lui est perpendiculaire. L'induction magnétique donne aux électrons un mouvement circulaire avec une vitesse de rotation proportionnelle à l'induction. La résonance cyclotronique électronique est atteinte lorsque la fréquence micro-onde est égale à la fréquence électronique de rotation, c'est-à-dire 2,45 GHz ce qui implique une induction de 875 gauss.

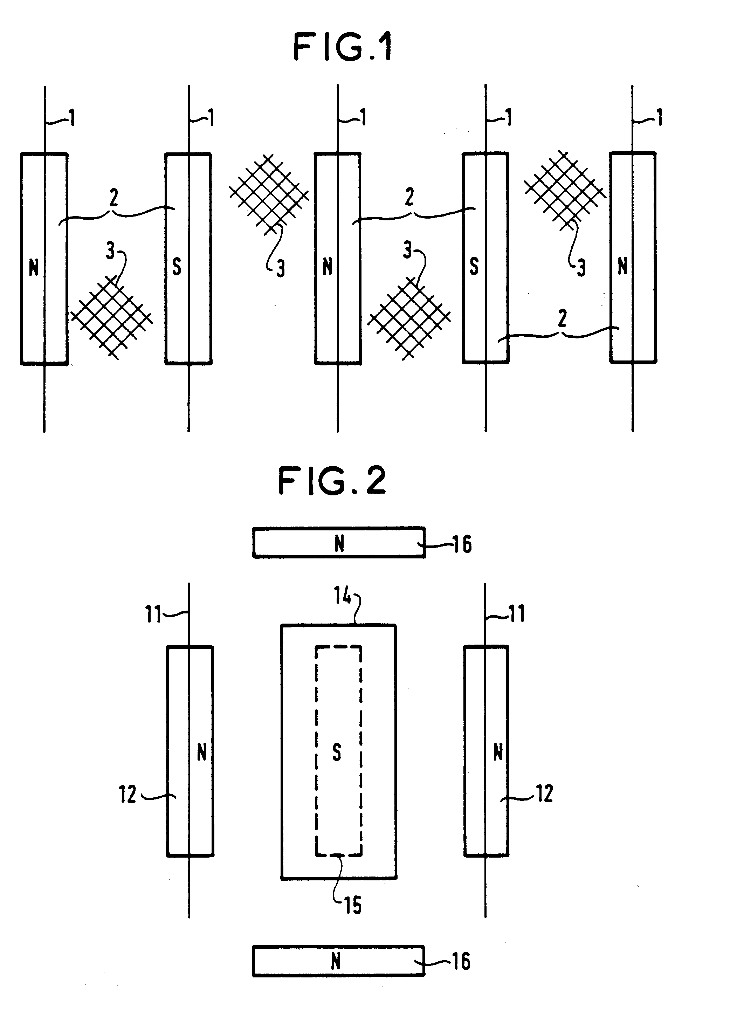

L'arrangement de sources de résonance cyclotronique électronique représenté à la figure 1 est un arrangement de type connu. Il a été mis en oeuvre pour réaliser un réacteur de gravure en plasma à basse pression et hautre densité. Cet arrangement peut être plan ou organisé en forme de cylindre.

Les sources de résonance cyclotronique électronique sont constituées par des applicateurs filaires ou antennes 1 placés à proximité de barreaux magnétiques 2. Une antenne 1 est placée de façon médiane en vis-à-vis d'un barreau magnétique 2. Les barreaux magnétiques présentent alternativement une face de polarité nord N et une face polarité sud S aux applicateurs filaires. Ces sources RCE sont disposées à la périphérie d'une enceinte de machine de gravure. Entre deux sources successives existent des lignes de champ magnétique transversales constituant une surface de confinement pour le plasma.

La géométrie du champ magnétique créé par les barreaux magnétiques 2 fait apparaître, par la polarité des aimants et à cause du gradient de champ existant perpendiculairement aux applicateurs (selon les rayons dans le cas d'une enceinte cylindrique), une dérive des électrons en sens inverse sur chaque feston (ou lobe) de lignes de champ magnétique. Ceci conduit à avoir une densité d'électrons entre les sources RCE plus importante à certains endroits qu'à d'autres. Ainsi dans le cas de la figure 1, les zones hachurées 3 sont des zones de plus forte densité d'électrons.

Avec cet arrangement, il peut arriver que les électrons attirent les ions qui sont donc plus nombreux à certains endroits. Une application de cette configuration de sources RCE à une machine de dépôt par pulvérisation cathodique pourrait donc conduire dans certains cas à des dépôts non uniformes.

Selon la figure 2, les sources RCE sont classiquement constituées par deux ensembles applicateur filaire 11-barreau magnétique 12. Les barreaux magnétiques présentent une face de même polarité aux applicateurs filaires, par exemple une face nord N. Les sources RCE sont placées de part et d'autre d'une électrode isolée polarisable 14 recouverte du matériau à pulvériser. La forme de l'électrode 14 peut être quelconque mais il est avantageux qu'elle soit rectangulaire, occupant le maximum de surface laissée libre entre les deux applicateurs.

Au voisinage de la surface de l'électrode 14, on dispose un barreau magnétique 15 identique aux barreaux 12 mais de polarité inverse. Dans le cas de la figure 2, l'électrode polarisable ou cathode 14 est disposée au-dessus du barreau magnétique 15. La cathode peut ainsi émettre sans être gênée par le barreau 15. Ce barreau magnétique 15 occupe une position centrale entre les deux sources RCE et est aligné parallèlement aux barreaux 12.

Des barreaux magnétiques 16, dits barreaux magnétiques de bouclage sont disposés transversalement, de part et d'autre de la cathode 14, de manière à réaliser avec les barreaux magnétiques 12 l'encadrement de cette cathode.

Les barreaux magnétiques 12 et 16 présentent la même polarité. Le barreau magnétique 15 présente une polarité inverse. On crée ainsi un circuit de confinement des électrons entre le barreau magnétique central 15 et les barreaux magnétiques d'encadrement 12 et 16.

Le plasma de haute densité est alors créé par l'application de l'onde électromagnétique à 2,45 GHz sur les antennes 11. Les électrons rapides issue du phénomène de résonance sont piégés dans chaque feston magnétique et le bouclage du champ aux extrémités assure une uniformisation de la zone d'ionisation élevée sur la surface de l'électrode 14 où le champ magnétique est parallèle au plan de l'électrode.

En disposant une polarisation de valeur typique aux procédés de pulvéristion cathodique, on provoque alors la pulvérisation de la cathode à une grande vitesse grâce à l'assistance du plasma. La géométrie du champ magnétique permet en outre de bénéficier d'un effet magnétron classique dû au champ électrique créé par la source de tension couplée à l'électrode.

La simplicité du dispositif selon l'invention est telle qu'il n'y a pas réellement de dimension longitudinale limite (c'est-à-dire selon la longueur des barreaux magnétiques 12) pourvu que le bouclage du champ magnétique soit respecté.

A titre d'exemple, la dimension entre les deux applicateurs filaires peut être de l'ordre de 20 cm, en disposant le barreau magnétique 15 et l'électrode de pulvérisation 14 à mi-distance des deux barreaux de même polarité 12.

De la même manière qu'en pulvérisation cathodique classique l'émission d'atomes se fait préférentiellement dans une direction perpendiculaire à l'électrode de sorte que le substrat sur lequel on désire déposer le matériau de l'électrode peut être situé dans un plan parallèle à cette électrode.

Pour bénéficier de l'avantage que procure la possibilité d'une grande dimension longitudinale pour l'électrode de pulvéristion, le substrat peut être animé d'un mouvement de translation et/ou de rotation afin de procurer une plus grande largeur d'émission.

**Revendications**

1.  Machine de dépôt par pulvérisation cathodique comprenant une enceinte de dépôt contenant un gaz maintenu à pression réduite et destiné à constituer un plasma par un mécanisme de résonance cyclotronique électronique, l'enceinte renfermant une cathode comportant le matériau à pulvériser et placée au voisinage de la zone de résonance, caractérisée en ce que :
    - le mécanisme de résonance cyclotronique électronique est créé par des ensembles situés de part et d'autre de la cathode (14), chaque ensemble comprenant un applicateur filaire (11) et un barreau magnétique (12),
    - un barreau magnétique, dit barreau magnétique central (15) est également disposé entre les deux ensembles et parallèlement à ceux-ci,
    - des barreaux magnétiques de bouclage (16) sont disposés à proximité de la cathode de manière à réaliser, avec les barreaux magnétiques (12) desdits ensembles, l'encadrement de la cathode (14) et du barreau magnétique central (15),
    - les barreaux magnétiques d'encadrement (12, 16) présentent tous une même polarité alors que le barreau magnétique central (15) présente une polarité inverse.

2.  Machine de dépôt selon la revendication 1, caractérisée en ce que la cathode (14) est rectangulaire.

3.  Machine de dépôt selon l'une des revendications 1 ou 2, caractérisé en ce que le barreau magnétique central (15) est disposé du côté opposé à la face d'émission de la cathode (14).

4.  Machine de dépôt selon l'une quelconque des revendications 1 à 3, caractérisé en ce que la cathode (14) est animée d'un mouvement de translation et/ou de rotation.

# FIG.1

# FIG.2

**Office européen des brevets**

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 209 469   (CNET & CNRS)<br>* abrégé; figures * * | 1 | H 01 J 37/32<br>H 01 J 37/34 |
| D,A | (& FR-A-2 583 250)<br>– – – | | H 05 H 1/46 |
| A | JOURNAL OF VACUUM SCIENCE AND TECHNOLOGY: PART A. vol. 8, no. 3, Juin 1990, NEW YORK US pages 2931 - 2938; R.R. BURKE ET AL.: 'Distributed electron cyclotron resonance in silicon processing: Epitaxy and etching.'<br>* page 2932 * *<br>– – – | 1 | |
| A | EP-A-0 173 164   (HITACHI SEISAKUSHO K.K.)<br>* page 24, alinéa 2 - page 25, dernier alinéa ; figure 8 * *<br>– – – – – | 1 | |

|  |
|---|
| **DOMAINES TECHNIQUES RECHERCHES (Int. Cl.5)** |
| H 01 J<br>H 05 H |

Le présent rapport de recherche a été établi pour toutes les revendications

| Lieu de la recherche | Date d'achèvement de la recherche | Examinateur |
|---|---|---|
| La Haye | 22 janvier 92 | SCHAUB G.G. |